**Europäisches Patentamt**

**European Patent Office**

**Office européen des brevets**

(19)

(11) Numéro de publication : **0 301 953 B1**

(12) ## FASCICULE DE BREVET EUROPEEN

(45) Date de publication du fascicule du brevet :
**03.06.92 Bulletin 92/23**

(51) Int. Cl.⁵ : **G01R 31/11, H01B 11/18**

(21) Numéro de dépôt : **88401932.4**

(22) Date de dépôt : **25.07.88**

(54) **Dispositif de détection de surchauffes dans un câble électrique et procédé de mise en oeuvre d'un tel dispositif.**

(30) Priorité : **27.07.87 FR 8710628**

(43) Date de publication de la demande :
**01.02.89 Bulletin 89/05**

(45) Mention de la délivrance du brevet :
**03.06.92 Bulletin 92/23**

(84) Etats contractants désignés :
**DE ES FR GB IT SE**

(56) Documents cités :
**FR-A- 2 337 411**
**US-A- 4 236 904**
**US-A- 4 361 799**
**PATENT ABSTRACTS OF JAPAN, vol. 11, no.**
**248 (P-604)[110], 13 août 1987, page 110 P 604;**
**& JP-A-62 55 546**

(73) Titulaire : **ALCATEL ALSTHOM COMPAGNIE
GENERALE D'ELECTRICITE
54, rue La Boétie
F-75382 Paris Cédex 08 (FR)**

(72) Inventeur : **Sinobad, Dusan
15-17 rue de Paris
F-91400 Orsay (FR)**

(74) Mandataire : **Weinmiller, Jürgen et al
Lennéstrasse 9 Postfach 24
W-8133 Feldafing (DE)**

EP 0 301 953 B1

Jouve, 18, rue Saint-Denis, 75001 PARIS

## Description

L'invention concerne un dispositif de détection de surchauffes dans un câble électrique et un procédé de mise en oeuvre de ce dispositif.

Lorsqu'un incident se produit sur des câbles enterrés ils sont en général précédés d'une forte émission thermique. La localisation de la zone de surchauffe est importante pour limiter le temps de réparation.

L'invention a pour objet de résoudre ce problème : elle permet, en effet, de connaître précisément l'endroit ou l'incident s'est produit, ce qui diminue fortement le coût de la réparation.

L'invention propose, à cet effet, un dispositif de localisation de surchauffes dans un câble électrique, caractérisé en ce qu'il comprend une ligne de mesure à l'extrémité de laquelle est couplé un circuit d'émission-réception de lumière, cette ligne étant formé d'un élément support, constitué d'une partie allongée munie de protubérances transversales, situé à l'intérieur d'une gaine thermorétractable, et d'au moins une fibre optique disposée entre cet élément support et cette gaine.

L'invention concerne également un procédé de mise en oeuvre de ce dispositif caractérisé en ce qu'on dispose la ligne de mesure le long de ce câble ; on couple à une extrémité de cette ligne le circuit d'émission-réception ; on émet au moins une impulsion lumineuse grâce à ce circuit d'émission-réception ; on effectue un comptage jusqu'à réception en retour de cette même impulsion ; et on effectue la comparaison à un temps référence correspondant à un câble en bon état.

Les caractéristiques et avantages de l'invention ressortiront d'ailleurs de la description qui va suivre, à titre d'exemple non limitatif, en référence aux figures annexées sur lesquelles :

– la figure 1 représente une coupe longitudinale de la ligne de mesure du dispositif de l'invention ;
– la figure 2 représente le circuit d'émission-réception du dispositif de l'invention ;
– les figures 3 à 7 illustrent schématiquement le fonctionnement du dispositif de l'invention.

Le dispositif de l'invention comprend une ligne de mesure 10 à l'extrémité de laquelle est couplé un circuit 11 d'émission-réception de lumière .

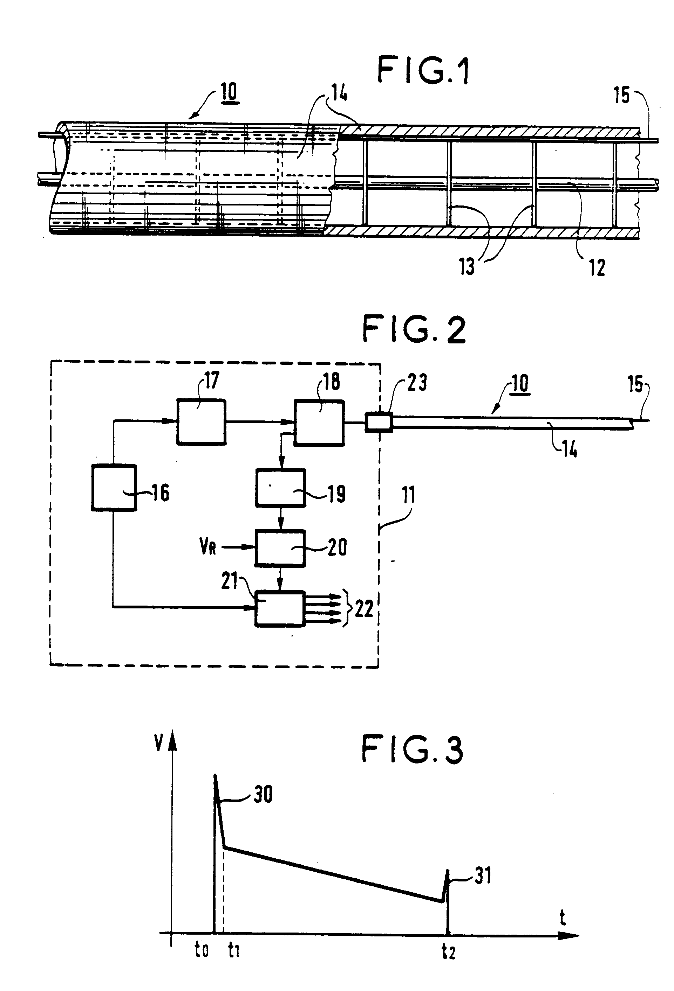

Cette ligne 10, représentée à la figure 1, comprend un élément support, formé d'une partie allongée 12 munie de protubérances transversales 13, situé à l'intérieur d'une gaine 14 thermorétractable, et au moins une fibre optique 15 disposée entre ce support (12, 13) et la gaine 14, par exemple parallèlement à la direction de la partie 12.

Les protubérances transversales sont réalisés par exemple à l'aide de disques 13 fixés sur un fil 12, ces disques 13 et ce fil 12 étant réalisés en matériaux peu déformables à des températures élevées, par exemple en métal.

Le circuit 11 d'emission-réception, représenté à la figure 2, comporte :

– un circuit de synchronisation 16,
– une diode émettrice de lumière 17,
– un coupleur 18,
– un récepteur de lumière 19,
– un comparateur de tension 20,
– un circuit de comptage du temps 21.

Le circuit de synchronisation 16 est relié d'une part à la diode émettrice 17 et d'autre part au circuit de comptage 21 qui comprend par exemple plusieurs sorties parallèles 22. La diode émettrice 17 est reliée à un connecteur 23, permettant d'effectuer la liaison à une première extrémité de la fibre 15, via un coupleur 18 qui est connecté également au récepteur 19. Ce récepteur 19 est relié au comparateur de tension 20 qui reçoit également une tension référence $V_R$ et est connecté au circuit de comptage 21.

Pour permettre de localiser l'endroit où un câble électrique a été surchauffé, on dispose la ligne de mesure le long de ce câble, on couple à une extrémité de cette ligne 10, en assurant un bon échange thermique, le circuit 11 d'émission-réception ; grâce à ce circuit 11 on émet au moins une impulsion lumineuse, on effectue un comptage jusqu'à réception en retour de cette même impulsion, et on effectue la comparaison à un temps référence correspondant à un câble en bon état.

En fonctionnement, le circuit de synchronisation 16 déclenche périodiquement l'émission par la diode émettrice 17 d'une impulsion lumineuse et le comptage d'un intervalle de temps, par le circuit 21. Une partie du signal lumineux est transmise par le coupleur 18 à la ligne 10. Le passage de ce signal lumineux provoquera le phénomène de rétrodiffusion " de Rayleigh".

Si la ligne 10 n'a pas été soumise à une élévation de température suffisante (environ 100° C) on pourra observer, par exemple, à la sortie du récepteur 18, un signal dont la forme est représentée sur la figure 3.

L'impulsion est émise au moment to. Une fraction de cette impulsion est transmise par le coupleur 18 vers le récepteur 19 et produit le pic 30 de forte amplitude. Ensuite entre les instants t1 et t2, le coupleur 18 transmet vers le récepteur 19 la lumière que rétrodiffuse la fibre 15, excitée par le passage de l'impulsion. L'amplitude du signal décroit réguliérement. Au moment t2, on observe une nouvelle brusque remontée 31 du signal, due à la réflexion de l'impulsion sur la seconde extrémité de la fibre 15.

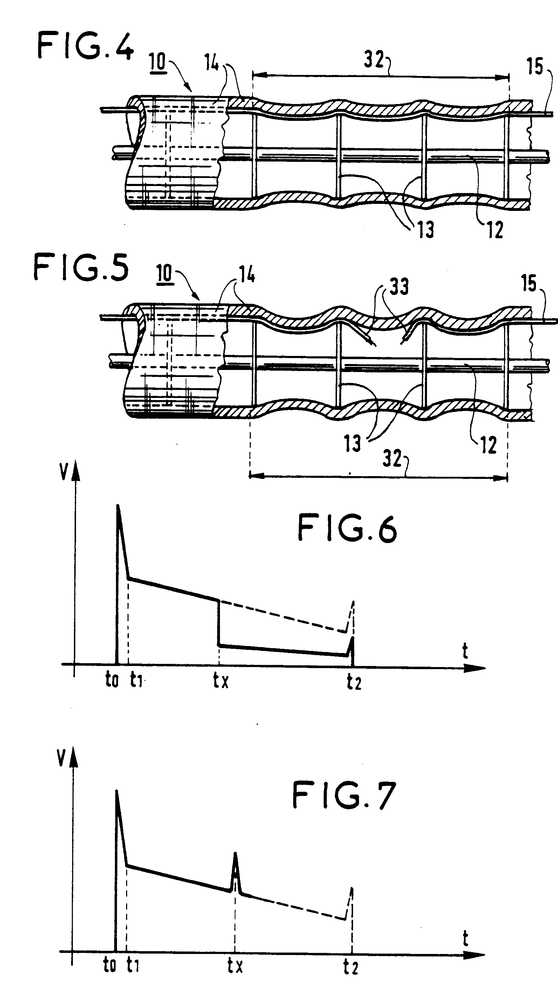

Si une partie du dispositif a subi un échauffement suffisant, cet échauffement provoque la déformation de la gaine thermorétractable dans une certaine zone 32 comme représenté sur la figure 4.

Lors d'un fort échauffement, en fonction des dispositions géométriques de l'ensemble, sous l'effet de rétreint de la gaine 14 deux cas peuvent se produire :

– soit la fibre devient, dans la zone 32 fortement incurvée entre deux disques 13, comme représenté à la figure 4,

– soit la fibre casse dans la zone 33 comme représenté à la figure 5.

Dans le cas d'une fibre fortement courbée, c'est-à-dire, si les dispositions géométriques prises sont telles que le rétreint de la gaine ne provoque pas la cassure de la fibre mais uniquement une forte courbure, comme représenté sur la figure 5, le signal de rétrodiffusion que l'on pourra observer aura la forme illustrée à la figure 6.

On observe une forte atténuation du signal de rétrodiffusion dans la zone de surchauffe 32, due au faible rayon de courbure de la fibre qui, de ce fait, perd sa propriété de "guide de lumière", la lumière sort du coeur de la fibre 15 et se perd dans la gaine 14.

Dans le cas, représenté à la figure 5, où la fibre 15 casse sous l'effet de l'échauffement, à la sortie du récepteur 19, on peut observer un signal de forme illustrée à la figure 7.

On observe que le signal de réflexion, provoqué par la cassure 33 de la fibre 15, intervient plus tôt que sur la figure 3. De plus, l'amplitude du signal de réflexion est très nettement supérieure à celle du signal de rétrodiffusion et, par conséquent, très facilement repérable.

Le comparateur 20, représenté sur la figure 2, a pour rôle de détecter rapidement l'instant ou le signal s'écarte de sa valeur "normale" : qu'il s'agisse d'amplification (cas de la fibre cassée) ou de l'atténuation (cas de la fibre courbée). La détection d'une forte variation intervenant avant l'instant t2 signifie qu'un échauffement important s'est produit à cet instant.

Dès que le signal atteint une valeur significative (que l'on peut régler à l'aide de la tension $V_R$) le comparateur délivre une impulsion dont la position dans le temps permet la localisation du défaut. En effet le compteur commence le comptage du temps avec l'apparition de l'impulsion émise par la diode émettrice 17. Sachant que la lumière se propage dans la fibre 15 à une vitesse connue et que le signal rétrodiffusé fait un double parcours avant d'arriver au récepteur, il suffit de prélever la valeur du compteur 21 au moment de l'apparition du signal de comparaison à la sortie du comparateur 20 pour connaître le temps du trajet de la lumière entre la première extrémité de la fibre 15 et l'endroit ou s'est produit le défaut. L'emplacement du défaut est alors facile à calculer.

On constate que les deux cas envisagés : cassure ou forte courbure d'une fibre, provoqués par le retreint d'une gaine thermorétractable montée autour d'un support de géométrie adéquate et portant une fibre optique, permettent de résoudre le problème posé. Dans les deux cas on doit utiliser un dispositif de mesure du signal de rétrodiffusion, mais cette mesure est facilitée par le très grand rapport signal/bruit dû aux méthodes utilisées.

Dans un exemple de réalisation l'élément support est constitué d'un fil 12 de cuivre de quelques millimètres de diamètre sur lequel ont été disposés des disques 13 de bronze béryllium d'environ 10 millimètres de diamètre et de quelques dizièmes de millimètres d'épaisseur espacés régulièrement tous les 10 millimètres environ.

Avec un tel dispositif on obtient une cassure pour une surchauffe d'environ 120° C.

Les impulsions émises par le circuit d'émission réception ont une amplitude de 20 à 40 ampères et une durée de quelques nanosecondes.

Le fil 12 peut être réalisé en composé polymérique sur lequel sont disposés perpendiculairement des plaquettes 13 métalliques ou en matière plastique régulièrement espacées.

**Revendications**

1. Dispositif de localisation de surchauffes dans un câble électrique, caractérisé on ce qu'il comprend une ligne de mesure (10) à l'extrémité de laquelle est couplé un circuit d'émission-réception de lumière, cette ligne (10) étant formé d'un élément support, constitué d'une partie allongée (12) munie de protubérances transversales (13), situé à l'intérieur d'une gaine thermorétractable (14), et d'au moins une fibre optique (15) disposée entre cet élément support (12, 13) et cette gaine (14).

2. Dispositif selon la revendication 1, caractérisé en ce qu'il comporte une fibre optique (15) de direction parallèle à la direction de la partie allongée (12).

3. Dispositif selon l'une quelconque des revendications 1 ou 2, caractérisé en ce que l'élément support est formé d'un fil (12) métallique sur lequel sont disposés perpendiculairement des disques (13) métalliques régulièrement espacés.

4. Dispositif selon la revendication 1 ou 2, caractérisé en ce que l'élément support est formé d'un fil (12) en composé polymérique sur lequel sont disposés perpendiculairement des plaquettes métalliques ou en matière plastique régulièrement espacées.

5. Dispositif selon l'une quelconque des revendication précédentes, caractérisé en ce que le circuit (11) d'émission-réception comprend :
– un circuit de synchronisation (16),
– une diode émettrice de lumière (17),
– un coupleur (18),
– un récepteur de lumière (19),
– un comparateur de tension (20),
– un circuit de comptage du temps 21.

6. Dispositif selon la revendication 5, caractérisé en ce que le circuit de synchronisation (16) est relié d'une part à la diode émettrice (17) et d'autre part au circuit de comptage (21) qui comprend par exemple plusieurs sorties parallèles (2), en ce que la diode émettrice (17) est reliée à un connecteur (23), permettant d'effectuer la liaison à une première extrémité de la fibre (15), via un coupleur (18) qui est connecté également au récepteur (19), en ce que ce récepteur (19) est relié au comparateur de tension (20) qui reçoit également une tension référence ($V_R$) et est connecté au circuit de comptage (21).

7. Procédé de mise en oeuvre du dispositif de localisation de surchauffes dans un câble électrique selon l'une quelconque des revendications 1 à 6, caractérisé en ce qu'on dispose la ligne (10) de mesure le long de ce câble ; on couple à une extrémité de cette ligne (10) le circuit (11) d'émission-réception ; on émet au moins une impulsion lumineuse grâce à ce circuit d'émission-réception ; on effectue un comptage jusqu'à réception en retour de cette même impulsion ; et on effectue la comparaison à un temps référence correspondant à un câble en bon état.

## Patentansprüche

1. Vorrichtung zur Lokalisierung von Überhitzungen in einem elektrischen Kabel, dadurch gekennzeichnet, daß sie eine Meßleitung (10) aufweist, an deren Ende ein Lichtsende- und Empfangskreis angekoppelt ist und die aus einem Trägerelement, das von einem länglichen, mit Vorsprüngen (13) in Querrichtung versehenen Teil (12) gebildet wird, wobei dieses Trägerelement sich im Inneren einer wärmeschrumpfenden Hülle (14) befindet, und aus mindestens einer Lichtleitfaser (15) besteht, die zwischen dem Trägerelement (12, 13) und der Hülle (14) angeordnet ist.

2. Vorrichtung nach Anspruch 1, dadurch gekennzeichnet, daß sie eine Lichtleitfaser (15) aufweist, die parallel zum länglichen Teil (12) verläuft.

3. Vorrichtung nach einem beliebigen der Ansprüche 1 oder 2, dadurch gekennzeichnet, daß das Trägerelement aus einem Metalldraht (12) gebildet wird, auf dem lotrecht gleichmäßig verteilte Metallscheiben (13) angeordnet sind.

4. Vorrichtung nach Anspruch 1 oder 2, dadurch gekennzeichnet, daß das Trägerelement aus einem Draht (12) aus einer Polymerverbindung besteht, auf dem lotrecht Plättchen aus Metall oder Kunststoffmaterial regelmäßig verteilt angeordnet sind.

5. Vorrichtung nach einem beliebigen der vorhergehenden Ansprüche, dadurch gekennzeichnet, daß der Sende- und Empfangskreis (11) aufweist:
   – einen Synchronisationskreis (16),
   – eine lichtaussendende Diode (17),
   – einen Koppler (18),
   – einen Lichtempfänger (19),
   – einen Spannungskomparator (20),
   – einen Zeitzählkreis 21.

6. Vorrichtung nach Anspruch 5, dadurch gekennzeichnet, daß der Synchronisationskreis (16) einerseits mit der lichtaussendenden Diode (17) und andererseits mit dem Zählkreis (21) verbunden ist, der zum Beispiel mehrere Parallelausgänge (2) aufweist, daß die lichtaussendende Diode (17) an einen Verbinder (23) angeschlossen ist, der die Verbindung mit einem ersten Ende der Faser (15) über einen Koppler (18) ermöglicht, der außerdem mit dem Empfänger (19) verbunden ist, daß dieser Empfänger (19) mit dem Spannungskomparator (20) verbunden ist, der außerdem eine Bezugsspannung ($V_R$) empfängt und mit dem Zählkreis (21) verbunden ist.

7. Verfahren zur Anwendung der Vorrichtung zur Lokalisierung von Überhitzungen in einem elektrischen Kabel nach einem beliebigen der Ansprüche 1 bis 6, dadurch gekennzeichnet, daß die Meßleitung (10) entlang dieses Kabels angeordnet wird, daß an ein Ende dieser Leitung (10) der Sende-Empfangskreis angekoppelt wird, daß von diesem Sende-Empfangskreis mindestens ein Lichtimpuls ausgesandt wird, daß ein Zählvorgang bis zum Rückerhalt dieses gleichen Impulses durchgeführt wird, und daß dann der Vergleich mit einer Bezugszeit durchgeführt wird, die einem ordnungsgemäßen Kabel entspricht.

## Claims

1. Apparatus for detecting overheating in an electric cable characterised in that it comprises a measuring line (10) to the end of which is connected a light transmit-receive circuit, said line (10) being in the form of a support member comprising an elongate part (12) provided with transverse protuberances (13) inside a heat-shrink sheath (14) and at least one optical fibre (15) disposed between said support member (12, 13) and said sheath (14).

2. Apparatus according to claim 1 characterised in that it comprises an optical fibre (15) parallel to the direction of the elongate part (12).

3. Apparatus according to claim 1 or claim 2 characterised in that the support member is in the form of a metal wire (12) on which are disposed at right angles regularly spaced metal disks (13).

4. Apparatus according to claim 1 or claim 2 characterised in that the support member is in the form of a polymer compound wire (12) on which are disposed at right angles regularly spaced metal or plastics material plates.

5. Apparatus according to any one of the preceding claims characterised in that the transmit-receive circuit (11) comprises:
   – a synchronisation circuit (16),
   – a light-emitting diode (17),
   – a coupler (18),
   – a light receiver (19),
   – a voltage comparator (20),

– a time measuring circuit 21.

6. Apparatus according to claim 5 characterised in that the synchronisation circuit (16) is connected to the light-emitting diode (17) and to the measuring circuit (21) which comprises for example a plurality of parallel outputs (2), in that the light-emitting diode (17) is connected to a connector (23) enabling connection to a first end of the fibre (15) via a coupler (18) which is also connected to the receiver (19), in that said receiver (19) is connected to the voltage comparator (20) which also receives a reference voltage ($V_R$) and is connected to the measuring circuit (21).

7. Method of using an apparatus for detecting overheating in an electric cable according to any one of claims 1 to 6 characterised in that the measurement line (1) is disposed along said cable, the transmit-receive circuit (11) is connected to one end of said line (10), at least one light pulse is transmitted by said transmit-receive circuit, the time is measured until the same pulse is received back, and the measured time is compared with a reference time representing a sound cable.

# FIG.1

# FIG.2

# FIG.3

FIG.4

FIG.5

FIG.6

FIG.7